# EUROPEAN PATENT SPECIFICATION

(11) **EP 1 854 218 B1**
(45) Date of publication and mention of the grant of the patent: **28.01.2009**
(21) Application number: 06706906.2
(22) Date of filing: 13.02.2006
(51) Int. Cl.: H03M 7/40, H03M 7/30

(54) **LOSSLESS ENCODING OF INFORMATION WITH GUARANTEED MAXIMUM BITRATE**
VERLUSTLOSE CODIERUNG VON INFORMATIONEN MIT GARANTIERTER MAXIMALER BITRATE
CODAGE SANS PERTE D'INFORMATIONS PRESENTANT UN DEBIT BINAIRE MAXIMAL GARANTI

(30) Priority: 22.09.2005 US 233351; 13.04.2005 US 670993 P
(43) Date of publication of application: 14.11.2007
(73) Proprietor: Fraunhofer-Gesellschaft zur Förderung der angewandten Forschung e.V., 80686 München (DE)
(72) Inventor: SPERSCHNEIDER, Ralph, 91320 Ebermannstadt (DE); HERRE, Jürgen, 91054 Buckenhof (DE); LINZMEIER, Karsten, 91058 Erlangen (DE); HILPERT, Johannes, 90411 Nürnberg (DE)
(74) Representative: Zinkler, Franz
(86) International application number: PCT/EP2006/001296
(87) International publication number: WO 2006/108465

(56) References cited:
- EP-A- 0 782 341
- US-A1- 2004 056 783
- YAMAGUCHI T ET AL: "AN EFFICIENT METHOD FOR COMPRESSING TEST DATA" PROCEEDINGS OF THE INTERNATIONAL TEST CONFERENCE. ITC '97. WASHINGTON, DC, NOV. 1 - 6, 1997, INTERNATIONAL TEST CONFERENCE, NEW YORK, NY : IEEE, US, vol. CONF. 28, 1 November 1997 (1997-11-01), pages 79-88, XP000800314 ISBN: 0-7803-4210-0
- BELL T ET AL: "MODELING FOR TEXT COMPRESSION" ACM COMPUTING SURVEYS, NEW YORK, NY, US, vol. 21, no. 4, December 1989 (1989-12), pages 557-591, XP000972666 ISSN: 0360-0300
- TAVAKOLI N ED - BANKMAN I N ET AL: "Lossless compression of medical images" COMPUTER-BASED MEDICAL SYSTEMS, 1991. PROCEEDINGS OF THE FOURTH ANNUAL IEEE SYMPOSIUM BALTIMORE, MD, USA 12-14 MAY 1991, LOS ALAMITOS, CA, USA,IEEE COMPUT. SOC, US, 12 May 1991 (1991-05-12), pages 200-207, XP010024187 ISBN: 0-8186-2164-8
- "INFORMATION TECHNOLOGY - CODING OF MOVING PICTURES AND ASSOCIATED AUDIO FOR DIGITAL STORAGE MEDIA AT UP TO ABOUT 1,5 -MBIT/S - PART 3: AUDIO TECHNOLOGIES DE L'INFORMATION - CODAGE DE L'IMAGE ANIMEE ET DU SON ASSOCIE POUR LES SUPPORTS DE STOCKAGE NUMERI" INTERNATIONAL STANDARD ISO/IEC, XX, XX, no. 11172-3, 1 August 1993 (1993-08-01), pages 1-158, XP008050513 cited in the application

## Description

### Field of the invention

The present invention relates to lossless encoding of information values, in particular to a concept to guarantee a maximum bit rate for an encoded representation of the information values.

### Background of the invention and prior art

In recent times, the multi-channel audio reproduction technique is becoming more and more important. This may be due to the fact that audio compression/encoding techniques such as the well-known mp3 technique have made it possible to distribute audio records via the Internet or other transmission channels having a limited bandwidth. The mp3 coding technique has become so famous because of the fact that it allows distribution of all the records in a stereo format, i.e., a digital representation of the audio record including a first or left stereo channel and a second or right stereo channel.

Nevertheless, there are basic shortcomings of conventional two-channel sound systems. Therefore, the surround technique has been developed. A recommended multi-channel-surround representation includes, in addition to the two stereo channels L and R, an additional center channel C and two surround channels Ls, Rs. This reference sound format is also referred to as three/two-stereo, which means three front channels and two surround channels. Generally, five transmission channels are required. In a playback environment, at least five speakers at five decent places are needed to get an optimum sweet spot in a certain distance of the five well-placed loudspeakers.

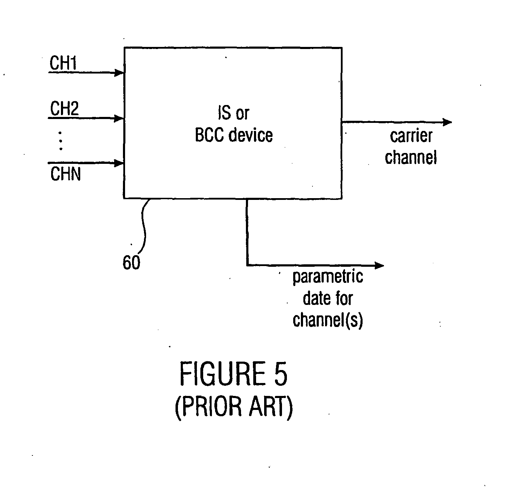

Several techniques are known in the art for reducing the amount of data required for transmission of a multi-channel audio signal. Such techniques are called joint stereo techniques. To this end, reference is made to Fig. 5, which shows a joint stereo device 60. This device can be a device implementing e.g. intensity stereo (IS) or binaural cue coding (BCC). Such a device generally receives - as an input - at least two channels (CH1, CH2, ... CHn), and outputs at least a single carrier channel and parametric data. The parametric data are defined such that, in a decoder, an approximation of an original channel (CH1, CH2, ... CHn) can be calculated.

Normally, the carrier channel will include subband samples, spectral coefficients, time domain samples etc., which provide a comparatively fine representation of the underlying signal, while the parametric data do not include such samples of spectral coefficients but include control parameters for controlling a certain reconstruction algorithm such as weighting by multiplication, time shifting, frequency shifting, phase shifting, etc. The parametric data, therefore, include only a comparatively coarse representation of the signal or the associated channel. Stated in numbers, the amount of data required by a carrier channel will be in the range of 60 - 70 kbit/s, while the amount of data required by parametric side information for one channel will typically be in the range of 1,5 - 2,5 kbit/s. An example for parametric data are the well-known scale factors, intensity stereo information or binaural cue parameters as will be described below.

The BCC Technique is for example described in the AES convention paper 5574, "Binaural Cue Coding applied to Stereo and Multi-Channel Audio Compression", C. Faller, F. Baumgarte, May 2002, Munich, in the IEEE WASPAA Paper "Efficient representation of spatial audio using perceptual parametrization", October 2001, Mohonk, NY, in "Binaural cue coding applied to audio compression with flexible rendering", C. Faller and F. Baumgarte, AES 113th Convention, Los Angeles, Preprint 5686, October 2002 and in "Binaural cue coding - Part II: Schemes and applications", C. Faller and F. Baumgarte, IEEE Trans. on Speech and Audio Proc., volume level. 11, no. 6, Nov. 2003.

In BCC encoding, a number of audio input channels are converted to a spectral representation using a DFT (Discrete Fourier Transform) based transform with overlapping windows. The resulting uniform spectrum is divided into non-overlapping partitions. Each partition approximately has a bandwidth proportional to the equivalent rectangular bandwidth (ERB). The BCC parameters are then estimated between two channels for each partition. These BCC parameters are normally given for each channel with respect to a reference channel and are furthermore quantized. The transmitted parameters are finally calculated in accordance with prescribed formulas (encoded), which may also depend on the specific partitions of the signal to be processed.

A number of BCC parameters do exist. The ICLD parameter, for example, describes the difference (ratio) of the energies contained in 2 compared channels. The ICC parameter (inter-channel coherence/correlation) describes the correlation between the two channels, which can be understood as the similarity of the waveforms of the two channels. The ICTD parameter (inter-channel time difference) describes a global time shift between the 2 channels whereas the IPD parameter (inter-channel phase difference) describes the same with respect to the phases of the signals.

One should be aware that, in a frame-wise processing of an audio signal, the BCC analysis is also performed frame-wise, i.e. time-varying, and also frequency-wise. This means that, for each spectral band, the BCC parameters are individually obtained. This further means that, in case an audio filter bank decomposes the input signal into for example 32 band pass signals, a BCC analysis block obtains a set of BCC parameters for each of the 32 bands.

A related technique, also known as parametric stereo, is described in J. Breebaart, S. van de Par, A. Kohlrausch, E. Schuijers, "High-Quality Parametric Spatial Audio Coding at Low Titrates", AES 116th Convention, Berlin, Preprint 6072, May 2004, and E. Schuijers, J. Breebaart, H. Purnhagen, J. Engdegard, "Low Complexity Parametric Stereo Coding", AES 116th Convention, Berlin, Preprint 6073, May 2004.

Summarizing, recent approaches for parametric coding of multi-channel audio signals ("Spatial Audio Coding", "Binaural Cue Coding" (BCC) etc.) represent a multi-channel audio signal by means of a downmix signal (could be monophonic or comprise several channels) and parametric side information ("spatial cues") characterizing its perceived spatial sound stage. It is desirable to keep the rate of side information as low as possible in order to minimize overhead information and leave as much of the available transmission capacity for the coding of the downmix signals.

One way to keep the bit rate of the side information low is to losslessly encode the side information of a spatial audio scheme by applying, for example, entropy coding algorithms to the side information.

Lossless coding has been extensively applied in general audio coding in order to ensure an optimally compact representation for quantized spectral coefficients and other side information. Examples for appropriate encoding schemes and methods are given within the ISO/IEC standards MPEG1 part 3, MPEG2 part 7 and MPEG4 part 3.

These standards and, for example, also the IEEE paper "Noiseless Coding of Quantized Spectral Coefficients in MPEG-2 Advanced Audio Coding", S. R. Quackenbush, J. D. Johnston, IEEE WASPAA, Mohonk, NY, October 1997 describe state of the art techniques that include the following measures to losslessly encode quantized parameters:
- Multi-dimensional Huffman Coding of quantized spectral coefficients
- Using a common (multi-dimensional) Huffman Codebook for sets of coefficients
- Coding the value either as a hole or coding sign information and magnitude information separately (i.e. have only Huffman codebook entries for a given absolute value which reduces the necessary codebook size, "signed" vs. "unsigned" codebooks)
- Using alternative codebooks of different largest absolute values (LAVs), i.e. different maximum absolute values within the parameters to be encoded
- Using alternative codebooks of different statistical distribution for each LAV
- Transmitting the choice of Huffman codebook as side information to the decoder
- Using "sections" to define the range of application of each selected Huffman codebook
- Differential encoding of scalefactors over frequency and subsequent Huffman coding of the result

Another technique for the lossless encoding of coarsely quantized values into a single PCM code is proposed within the MPEG1 audio standard (called grouping within the standard and used for layer 2). This is explained in more detail within the standard ISO/IEC 11172-3:93.

The publication "Binaural cue coding - Part II: Schemes and applications", C. Faller and F. Baumgarte, IEEE Trans. on Speech and Audio Proc., volume level. 11, no. 6, Nov. 2003 gives some information on coding of BCC parameters. It is proposed, that quantized ICLD parameters are differentially encoded
- over frequency and the result is subsequently Huffman encoded (with a one-dimensional Huffman code)
- over time and the result is subsequently Huffman encoded (with a one-dimensional Huffman code),
and that finally, the more efficient variant is selected as the representation of an original audio signal.

As mentioned above, it has been proposed to optimize compression performance by applying differential coding over frequency and, alternatively, over time and select the more efficient variant. The selected variant is then signaled to a decoder via some side information.

US2004/0056783A1 discloses an encoder and its corresponding decoder which selects among different lossless entropy encoders dependent on the coding rate.

The prior art techniques described above are useful to reduce the amount of data that, for example, has to be transmitted by means of an audio- or videostream. Using the described techniques of lossless encoding based on entropy-coding schemes generally results in a bit stream with a non-constant bit rate.

Although the prior art techniques are suited to significantly reduce the size of the data to be transferred, they all share one basic shortcoming. Since entropy coding mainly compresses information values that are believed to occur often within the data set to be compressed, a number of consecutively occurring rare parameters will result in very high code length. Since such a parameter combination is likely to occur sometimes within a complex data stream to be encoded, a resulting bit stream will in general have sections with a comparatively high bit rate.

If, within these sections, the bit rate exceeds the maximum feasible bit rate of the transport medium, e.g. the maximum net data rate of a wireless connection during a streaming application, the transfer of encoded data will be stalled or even interrupted, being of course most disadvantageous.

### Summary of the invention

It is the object of the present invention to provide a concept to losslessly encode information values, simultaneously guaranteeing a lower maximum bit rate.

In accordance with a first aspect of the present invention, this object is achieved by an encoder for encoding of information values that are described by more than one bit to derive an encoded representation of the information values, comprising: a bit estimator adapted to estimate a number of information units required for encoding the information values using a first encoding rule and using a second encoding rule, the first encoding rule being such that the information values, when encoded, result in encoded representations having different numbers of information units, the second encoding rule being such that the information values, when encoded, result in encoded representations having identical numbers of information units, wherein the encoded representation is derived from a combination of information values having at least two information values combined; and a provider adapted to provide an encoded representation being derived using the encoding rule resulting in the smaller number of information units for the encoded representation and to provide a rule information indicating the encoding rule on which the encoded representation is based.

In accordance with a second aspect of the present invention, this object is achieved by a decoder for decoding an encoded representation of information values that are described by more than one bit and for processing a rule information indicating an encoding rule used for encoding the information values, comprising: a receiver for receiving the encoded representation and the rule information; and a decompressor for decoding the encoded representation, the decompressor being operative to derive the information value using, depending on the rule information, a first decoding rule or a second decoding rule, the first decoding rule being such that the information values are derived from encoded representations having different numbers of information units and using a second decoding rule, the second decoding rule being such that the information values are derived from encoded representations having identical numbers of information values, wherein the information values are derived from combinations of information values having at least two information values combined within the encoded representation.

In accordance with a third aspect of the present invention, this object is achieved by a method for encoding of information values that are described by more than one bit to derive an encoded representation of the information values, the method comprising: estimating a number of information units required for encoding the information values using a first encoding rule and using a second encoding rule, the first encoding rule being such that the information values, when encoded, result in encoded representations having different numbers of information units, the second encoding rule being such that the information values, when encoded, result in encoded representations having identical numbers of information units, wherein the encoded representation is derived from a combination of information values having at least two information values combined; and providing an encoded representation being derived using the encoding rule resulting in the smaller number of information units for the encoded representation and to provide a rule information indicating the encoding rule on which the encoded representation is based.

In accordance with a fourth aspect of the present invention, this object is achieved by a computer program implementing the above method, when running on a computer.

In accordance with a fifth aspect of the present invention, this object is achieved by a method for decoding an encoded representation of information values that are described by more than one bit and for processing a rule information indicating an encoding rule used for encoding the information values, the method comprising: receiving the encoded representation and the rule information; and decoding the encoded representation using, depending on the rule information, a first decoding rule or a second decoding rule, the first decoding rule being such that the information values are derived from encoded representations having different numbers of information units and using a second decoding rule, the second decoding rule being such that the information values are derived from encoded representations having identical numbers of information values, wherein the information values are derived from combinations of information values having at least two information values combined within the encoded representation.

In accordance with a sixth aspect of the present invention, this object is achieved by a computer program implementing the above method, when running on a computer.

In accordance with a seventh aspect of the present invention, this object is achieved by an encoded representation of information values, wherein the encoded representation includes: a first part generated using a first encoding rule, the first encoding rule being such that the information values, when encoded, result in encoded representations having different numbers of information units; a second part generated using a second encoding rule, the second encoding rule being such that the information values, when encoded, result in encoded representations having identical numbers of information units, wherein the encoded representation is derived from a combination of information values having at least two information values combined; and a rule information indicating the encoding rule used.

The present invention is based on the finding that a compact encoded representation of information values not exceeding a predefined size can be derived when a first encoding rule generating an encoded representation of the information values of variable-length is compared to a second encoding rule generating an encoded representation of the information values of fixed length and when the encoding rule resulting in the encoded representation requiring the lower number of information units is chosen.
Thus, the maximum bit rate can be guaranteed to be at most the bit rate of the second encoding rule deriving the second encoded representation. By signaling the choice of the encoding rule by some rule information together with the encoded representation of the information values, the correct information values can later on be derived on a decoder side, using a decoding rule matching with the encoding rule used during the encoding.

The principle shall be summarized in more detail in the following paragraphs presuming a properly designed variable length code matching the statistics of the information values to be encoded.

When applying entropy coding of quantized values, the actual demand required for representing a data set is known to depend on the values to be coded. Generally, the more likely the values are the less bits are consumed. Conversely, very unlikely data sets will require a high bit rate. In this way, it may happen that a very high data rate is required for some data blocks, which can be disadvantageous, e.g. if the transmission channel has a limited transmission capacity.

The proposed method is able to guarantee a know upper limit for the bit demand of encoding entropy coded data sets, even for the case of very infrequent values. Specifically, the method ensures that the bit demand does not exceed the bit demand for using a PCM code. The encoding method can be summarized as follows:
- The data set is encoded using a regular entropy (e.g. Huffman) coding process. The resulting bit demand is stored.
- The bit demand for a PCM representation is calculated. Note that this is simply the number of values to be coded multiplied by the PCM code length or by a fraction of the PCM code length and is thus easy to compute.
- If the bit demand for entropy coding exceeds the bit demand for PCM encoding, PCM encoding is selected and signaled to the decoder via an appropriate side information.

The decoding stage works correspondingly.

In a preferred embodiment of the current invention, quantized values are encoded comparing an entropy coding scheme and a PCM code.

In the above-described embodiment of the current invention, the maximum bit rate is defined by the word length of the PCM code. Thus, knowing this word length, one can advantageously design a system of an encoder, a transport medium and a decoder, assuring a safe operation by selecting the transport medium such that its transport capacity exceeds the maximum bit rate defined by the PCM code.

In a second preferred embodiment, based on the previous embodiment of the present invention, several information values are additionally combined into a single value which can be represented more efficiently using PCM encoding, i.e. which has a range close to a power of two. The grouping is described in more detail by the following example:

Values of a quantized variables with a range of 0...4 (i.e. 5 possible different values) cannot be efficiently represented with a PCM code since the smallest possible code length of 3 bits wastes 3 out of the possible 2^3=8 values. Combining 3 such variables (thus having 5^3=125 possible combinations) into a single code of 7 bits length significantly reduces the amount of redundancy since 5^3=125 is almost 2^7=128.

Consequently, a combined implementation of the proposed concept for upper-bounding the bit demand with this approach will use a grouped PCM encoding for determining the upper limit of data rate (and the fall-back way of encoding) for the PCM alternative.

This combined implementation has the obvious advantage of being able to further reduce the maximum bit rate.

### Brief description of the drawings

Preferred embodiments of the present invention are subsequently described by referring to the enclosed drawings, wherein:
- Fig. 1: shows an inventive encoder;
- Fig. 2: shows an example of the bit estimation according to the inventive concept;
- Fig. 3a: shows grouping of 2 information values prior to PCM-encoding;
- Fig. 3b: shows grouping of 3 information values;
- Fig. 4: shows an inventive decoder; and
- Fig. 5: shows a multi-channel audio encoder according to the prior art.

### Detailed description of the preferred embodiments

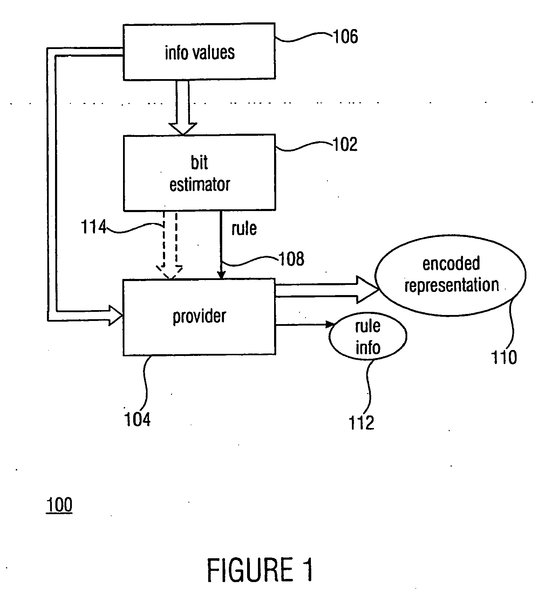

Fig. 1. shows a block diagram of an inventive encoder to encode information values or to derive an encoded representation of the information values, guaranteeing a fixed maximum bit rate. The encoder 100 comprises a bit estimator 102 and a provider 104.

Information values 106 to be encoded are input to the bit estimator 102 and to the provider 104. In one possible implementation the bit estimator 102 estimates the number of information units required by using a first encoding rule and using a second encoding rule. The information, which encoding rule results in the encoded representation requiring the lower number of information units, is made available to the provider 104 via the rule-data link 108. The provider 104 then encodes the information values 106 with the signaled encoding rule and delivers the encoded representation 110 as well as a rule information 112, indicating the encoding rule used, at his outputs.

In a modification of the previously described embodiment of the invention, the bit estimator 102 encodes the information values 106 using the first and the second encoding rule. The bit estimator 102 then counts the information units required for the two encoded representations and delivers the encoded representation with the lower number of information units and the rule information to the provider 104. The possible transfer of an already encoded representation from the bit estimator 102 to the provider 104 is indicated by the dashed data link 114 in Fig. 1. The provider 104 then simply forwards the already encoded representation to its output and additionally delivers the rule information 112.

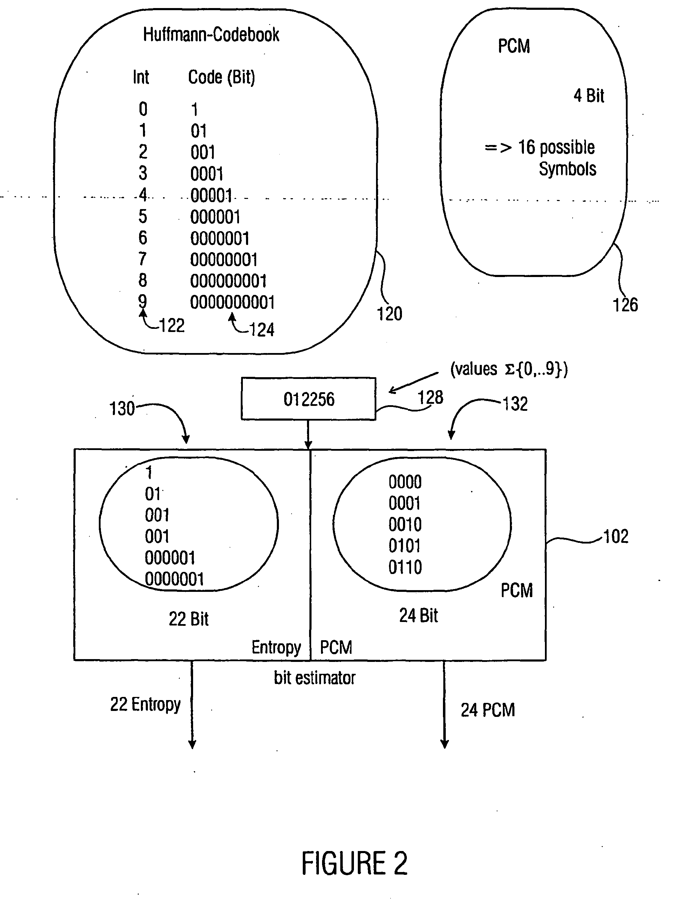

Fig. 2 illustrates how the bit estimator 102 estimates the number of bits necessary to derive an encoded representation by comparing a Huffman code with a PCM code.

The Huffman code-book 120 is used to assign integer values 122 to code-words 124 that are represented by a sequence of bits. It is to be noted here, that the Huffman-Codebook is chosen as simple as possible here to focus on the basic idea of the inventive concept.

The PCM code used for the comparison and to guarantee a maximum constant bit rate consists of PCM code-words of a length of 4 bits, allowing for 16 possible code-words, as indicated within the PCM description 126.

In the simple example shown here, the information values 128 to be encoded are represented by six consecutive integers (011256), that means, each information value has only ten possible settings. The information values 128 are input to the bit estimator 102, which derives the number of bits necessary to build the encoded representation using the Huffman code-book, as indicated in the Huffman section 130 of the bit estimator 102 and using the PCM representation, as indicated in the PCM section 132. As can be seen in Fig. 2, the entropy-encoded representation of the information values requires 22 bits, whereas the PCM representation requires 24 bits, being the number of information values multiplied with the bit length of a single PCM code-word. An inventive encoder would in the case of Fig. 2 decide to go for the entropy-encoded representation of the information values and signal an appropriate rule information that is output along with the entropy-encoded representation.

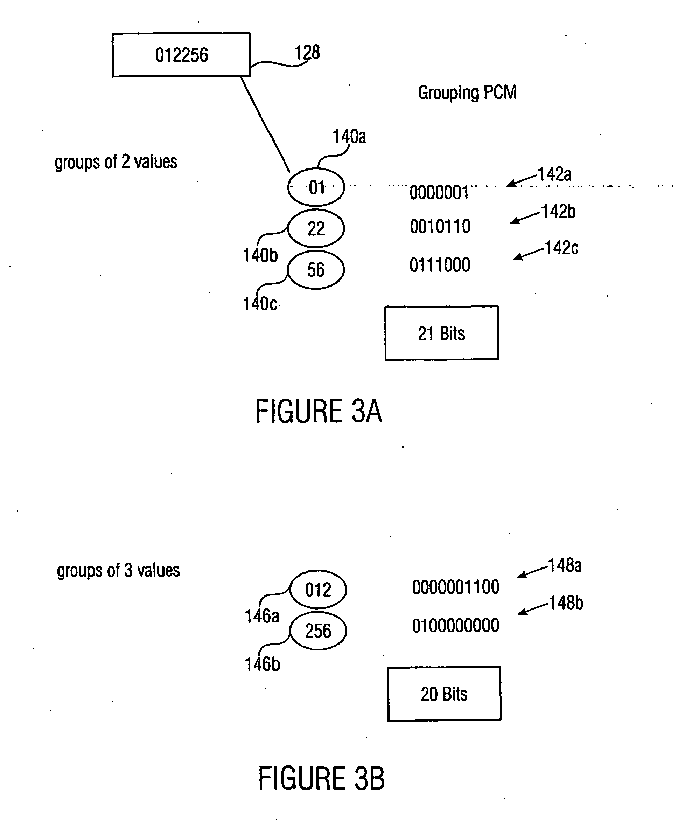

Figures 3a and 3b show possibilities to further decrease the maximum bit rate by advantageously grouping the information values 128 together to form groups of information values that are PCM encoded.

In the following, the same information values 128 as in Fig. 2 are used to emphasize the impact the PCM grouping can have on the inventive concept of encoding information values.

As again a single information value only has 10 possible settings, one can advantageously combine two consecutive information values to groups of information values 140a to 140c before building a PCM representation of the then combined values. This is possible, since a 7-bit PCM code allows for 128 different combinations, whereas a group of two arbitrary information values can only build 100 different combinations.

Each of the groups 140a - 140c of information values is now assigned to a single 7-Bit-PCM code-word 142a - 142c. As can be seen from Fig. 3a, applying the grouping strategy prior to building a PCM representation results in an encoded representation of the information values.128 having only 21 bits, compared to the 24 bits required for the non-grouped PCM representation of Fig. 2. In the above grouping strategy, a mean value of 3.5 bits is consumed by each information value within a data stream (7 bits / 2 information values).

As Figure 3b shows, one can further increase the efficiency of the grouping by grouping 3 values together in groups of information values 146a and 146b. These can form 1000 possible combinations, that can be covered by a 10-Bit-PCM code, as shown by the PCM-codewords 148a and 148b in Fig. 3. Thus, the PCM representation requires only 20 bits, further decreasing the mean value of bits per information value to 3.33 (10/3).

As one can clearly see, the bit rate needed for encoding can benefit significantly by the grouping of the values, as the maximum bit rate would be 12.5% (16.7%) lower for the given examples of Figures 3a and 3b. Additionally applying the grouping to the example of Fig. 2 would even maze the bit estimator 102 go for a different decision and signal that the PCM code yields the encoded representation requiring the lower number of bits.

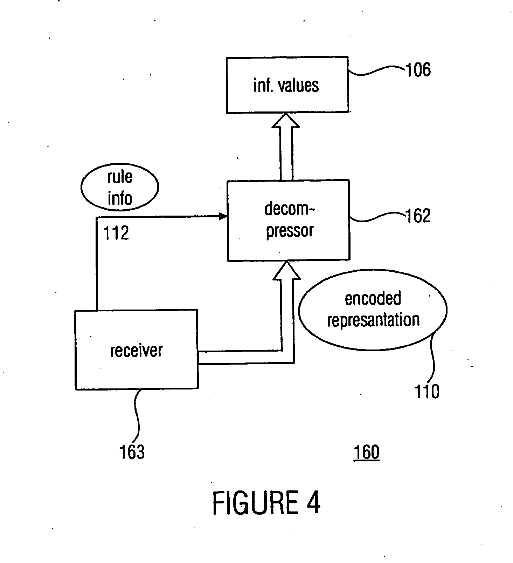

Fig. 4 shows a block diagram of a decoder according to the present invention. The decoder 160 comprises a decompressor 162 and a receiver 163 for providing an encoded representation 110 and a rule information 112, indicating an encoding rule used for encoding the information values.

The decompressor 162 processes the rule information 112 to derive a decoding rule appropriate to derive the information values 106 from the encoded representation 110.

The decompressor 162 then decompresses the encoded representation 110 using the decoding rule and provides the information values 106 at its output.

The descriptions in the previous paragraphs detail the inventive concept by comparing an entropy encoding scheme producing a code of variable bit length with a PCM encoding scheme producing a code of fixed bit length. The inventive concept is in no way limited to the types of codes that are compared during the encoding process. Basically, any combination of two or more codes is appropriate to be compared and to derive an encoded representation of information values being as compact as possible, especially being more compact than if derived by using just one code.

The present invention is described in the context of audio-encoding, where parameters, describing for example spatial properties of an audio signal, are encoded and decoded according to the inventive concept. The inventive concept, guaranteeing a maximum bit rate for encoded content, can advantageously be applied to any other parametric representation or information values also.

Implementations where previously quantized parameters are entropy encoded are specially suited, since then the encoding efficiency is expected to be high. Nonetheless, also the direct spectral representation of an audio or video signal may be used as input to the inventive encoding scheme. Especially, when a signal is described by various different portions of the signal following each other in time, wherein the time portions are described by parameters comprising a frequency representation of the signal, the encoding measures described above can be employed over frequency and over time. Also PCM grouping may be applied, grouping together parameters over time or over frequency.

Although the inventive decoder, as described above, derives the information which decoding rule to use to decode the encoded representation by means of a rule information signaling the rule to the decoder, it is also possible in an alternative embodiment that the decoder 160 derives from the encoded representation 110 directly what decoding rule to use, for example by recognizing a special sequence of bits within the encoded representation, having the advantage that the side information signaling the rule information can be omitted.

Depending on certain implementation requirements of the inventive methods, the inventive methods can be implemented in hardware or in software. The implementation can be performed using a digital storage medium, in particular a disk, DVD or a CD having electronically readable control signals stored thereon, which cooperate with a programmable computer system such that the inventive methods are performed. Generally, the present invention is, therefore, a computer program product with a program code stored on a machine readable carrier, the program code being operative for performing the inventive methods when the computer program product runs on a computer. In other words, the inventive methods are, therefore, a computer program having a program code for performing at least one of the inventive methods when the computer program runs on a computer.

While the foregoing has been particularly shown and described with reference to particular embodiments thereof, it will be understood by those skilled in the art that various other changes in the form and details may be made without departing from the scope of the claims. It is to be understood that various changes may be made in adapting to different embodiments without departing from the broader concepts disclosed herein and comprehended by the claims that follow.

## Claims

1. Encoder for lossless encoding of information values describing an audio signal, the information values described by more than one bit to derive an encoded representation of the information values, comprising:
a bit estimator adapted to estimate a number of information units required for encoding the information values using a first encoding rule and using a second encoding rule,
the first encoding rule being such that the information values, when encoded, result in encoded representations having different numbers of information units, **characterised in that**
the second encoding rule being such that the information values, when encoded, result in encoded representations having identical numbers of information units, wherein the encoded representation is derived assigning a single codeword of fixed length to a combination of information values having at least two information values combined; and
a provider adapted to provide an encoded representation being derived using the encoding rule resulting in the smaller number of information units for the encoded representation and to provide a rule information indicating the encoding rule on which the encoded representation is based.

2. Encoder in accordance with claim 1, in which the first encoding rule is such that the number of information units required by the encoded representation of a fixed number of information values depends on the underlying information values.

3. Encoder in accordance with claim 1, in which the first encoding rule is such that deriving the encoded representation includes using a Huffman code-book.

4. Encoder in accordance with claim 1, in which the first encoding rule is such, that deriving the encoded representation includes deriving a differentially encoded representation of the information values.

5. Encoder in accordance with claim 4, in which the differentially encoded representation is differentially encoded in time or in frequency.

6. Encoder in accordance with claim 1, in which the information values include BCC parameters describing the spatial properties of a multi-channel audio signal and in which the BCC parameters are chosen from the following list of BCC parameters:
ICC (inter-channel coherence/correlation)
ICLD (inter-channel level difference)
ICTD (inter-channel time difference)
IPD (inter-channel phase difference).

7. Encoder in accordance with claim 1, in which the information units are bits.

8. Decoder for decoding an encoded representation of information values describing an audio signal that are described by more than one bit and for processing a rule information indicating an encoding rule used for encoding the information values, comprising:
a receiver for receiving the encoded representation and the rule information; and
a decompressor for decoding the encoded representation, the decompressor being operative to derive the information values using, depending on the rule information, a first decoding rule or a second decoding rule,
the first decoding rule being such that the information values are derived from encoded representations having different numbers of information units; and **characterised in that**
the second decoding rule being such that the information values are derived from codewords of fixed length having identical numbers of information values, wherein the information values are derived from combinations of information values having at least two information values combined that are represented by one codeword of fixed length.

9. Decoder in accordance with claim 8, in which the first decoding rule is such that deriving the information values includes using a Huffman code-book.

10. Decoder in accordance with claim 8, in which the second decoding rule is such that deriving the information values includes assigning a combination of information values having at least two information values combined to a PCM codeword of the encoded representation.

11. Decoder in accordance with claim 8, in which the encoded representation of information values is based on information values comprising parameters describing aframe of an audio signal.

12. Decoder in accordance with claim 8, in which the encoded representation of information values is based on information values comprising BCC parameter describing the spatial properties of a multi-channel audio signal and in which the BCC parameters are chosen out of the following list of BCC parameters:
ICC (inter-channel coherence/correlation)
ICLD (inter-channel level difference)
ICTD (inter-channel time difference)
IPD (inter-channel phase difference).

13. A method for lossless, encoding of information values describing an audio signal, the information values described by more than one bit, to derive an encoded representation of the information values, the method comprising:
estimating a number of information units required for encoding the information values using a first encoding rule and using a second encoding rule,
the first encoding rule being such that the information values, when encoded, result in encoded representations having different numbers of information units, **characterised in that**
the second encoding rule being such that the information values, when encoded, result in encoded representations having identical numbers of information units, wherein the encoded representation is derived assigning a codeword of fixed length to a combination of information values having at least two information values combined; and
providing an encoded representation being derived using the encoding rule resulting in the smaller number of information units for the encoded representation and to provide a rule information indicating the encoding rule on which the encoded representation is based.

14. A method for decoding an encoded representation of information values describing an audio signal, the information values described by more than one bit, and for processing a rule information indicating an encoding rule used for encoding the information values, the method comprising:
receiving the encoded representation and the rule information; and
decoding the encoded representation using, depending on the rule information, a first decoding rule or a second decoding rule,
the first decoding rule being such that the information values are derived from codewords of fixed length having different numbers of information units, **characterised in that**
the second decoding rule being such that the information values are derived from encoded representations having identical numbers of information values, wherein the information values are derived from combinations of information values having at least two information values combined that are represented by one codeword of fixed length.

15. Computer program having a program code for performing, when running on a computer, a method for lossless encoding of information values describing an audio signal, the information values described by more than one bit, to derive an encoded representation of the information values, the method comprising:
estimating a number of information units required for encoding the information values using a first encoding rule and using a second encoding rule,
the first encoding rule being such that the information values, when encoded, result in encoded representations having different numbers of information units, **characterised in that**
the second encoding rule being such that the information values, when encoded, result in encoded representations having identical numbers of information units, wherein the encoded representation is derived assigning a single codeword of fixed length to a combination of information values, having at least two information values combined; and
providing an encoded representation being derived using the encoding rule resulting in the smaller number of information units for the encoded representation and to provide a rule information indicating the encoding rule on which the encoded representation is based.

16. Computer program having a program code for performing, when running on a computer, a method for decoding an encoded representation of information values describing an audio signal, the information values described by more than one bit, and for processing a rule information indicating an encoding rule used for encoding the information values, the method comprising:
receiving the encoded representation and the rule information; and
decoding the encoded representation using, depending on the rule information, a first decoding rule or a second decoding rule,
the first decoding rule being such that the information values are derived from encoded representations having different numbers of information units; and **characterised in that**
the second decoding rule being such that the information values are derived from codewords of fixed length having identical numbers of information values, wherein the information values are derived from combinations of information values having at least two information values combined that are represented by one codeword of fixed length.

17. Encoded representation of information values describing an audio signal, wherein the encoded representation includes:
a first part generated using a first encoding rule, the first encoding rule being such that the information values, when encoded, result in encoded representations having different numbers of information units **characterised in that**
a second part generated using a second encoding rule, the second encoding rule being such that the information values, when encoded, result in codewords of fixed length having identical numbers of information units, wherein the encoded representations is derived from a combination of information values having at least two
information values combined that are represented by one codeword of fixed length; and
a rule information indicating the encoding rule used.

18. Encoded representation in accordance with claim 17, which is stored on a computer-readable medium.

## Patentansprüche

1. Codierer zum verlustfreien Codieren von Informationswerten, die ein Audiosignal beschreiben, wobei die Informationswerte durch mehr als ein Bit beschrieben werden, um eine codierte Darstellung der Informationswerte abzuleiten, mit folgenden Merkmalen:
einer Bitschätzeinrichtung, die dahin gehend angepasst ist, eine Anzahl von Informationseinheiten, die zum Codieren der Informationswerte unter Verwendung einer ersten Codierungsregel und unter Verwendung einer zweiten Codierungsregel benötigt werden, zu schätzen,
wobei die erste Codierungsregel dahin gehend lautet, dass die Informationswerte, wenn sie codiert werden, zu codierten Darstellungen führen, die eine unterschiedliche Anzahl von Informationseinheiten aufweisen, **dadurch gekennzeichnet, dass**
die zweite Codierungsregel dahin gehend lautet, dass die Informationswerte, wenn sie codiert werden, zu codierten Darstellungen führen, die eine identische Anzahl von Informationseinheiten aufweisen, wobei die codierte Darstellung abgeleitet wird, indem ein einziges Codewort einer feststehenden Länge einer Kombination von Informationswerten, bei der zumindest zwei Informationswerte kombiniert sind, zugewiesen wird; und
einer Bereitstellungseinrichtung, die dahin gehend angepasst ist, eine codierte Darstellung bereitzustellen, die unter Verwendung der Codierungsregel abgeleitet wird, die zu der kleineren Anzahl von Informationseinheiten für die codierte Darstellung führt, und Regelinformationen bereitzustellen, die die Codierungsregel angeben, auf der die codierte Darstellung beruht.

2. Codierer gemäß Anspruch 1, bei dem die erste Codierungsregel dahin gehend lautet, dass die Anzahl von Informationseinheiten, die seitens der codierten Darstellung einer feststehenden Anzahl von Informationswerten benötigt wird, von den zugrundeliegenden Informationswerten abhängt.

3. Codierer gemäß Anspruch 1, bei dem die erste Codierungsregel dahin gehend lautet, dass das Ableiten der codierten Darstellung, ein Huffman-Codebuch umfasst.

4. Codierer gemäß Anspruch 1, bei dem die erste Codierungsregel dahin gehend lautet, dass das Ableiten der codierten Darstellung ein Ableiten einer differentiell codierten Darstellung der Informationswerte umfasst.

5. Codierer gemäß Anspruch 4, bei dem die differentiell codierte Darstellung in Bezug auf Zeit oder Frequenz differentiell codiert ist.

6. Codierer gemäß Anspruch 1, bei dem die Informationswerte BCC-Parameter (BCC, binaural cue coding, Binaural-Hinweis-Codierung) umfassen, die die räumlichen Eigenschaften eines Mehrkanalaudiosignals beschreiben, und bei dem die BCC-Parameter aus der folgenden Liste von BCC-Parametern ausgewählt sind:
ICC (inter-channel coherence/correlation, Zwischen-Kanal-Kohärenz/-Korrelation)
ICLD (inter-channel level difference, Zwischen-Kanal-Pegel-Differenz)
ICTD (inter-channel time difference, Zwischen-Kanal-Zeit-Differenz)
IPD (inter-channel phase difference, Zwischen-Kanal-Phase-Differenz).

7. Codierer gemäß Anspruch 1, bei dem die Informationseinheiten Bits sind.

8. Decodierer zum Decodieren einer codierten Darstellung von Informationswerten, die ein Audiosignal beschreiben und die durch mehr als ein Bit beschrieben werden, und zum Verarbeiten von Regelinformationen, die eine zum Codieren der Informationswerte verwendete Codierungsregel angeben, mit folgenden Merkmalen:
einem Empfänger zum Empfangen der codierten Darstellung und der Regelinformationen; und
einer Dekomprimierungseinrichtung zum Decodieren der codierten Darstellung, wobei die Dekomprimierungseinrichtung dahin gehend wirksam ist, die Informationswerte unter Verwendung, je nach den Regelinformationen, einer ersten Decodierungsregel oder einer zweiten Decodierungsregel abzuleiten,
wobei die erste Decodierungsregel dahin gehend lautet, dass die Informationswerte von codierten Darstellungen abgeleitet sind, die eine unterschiedliche Anzahl von Informationseinheiten aufweisen; und **dadurch gekennzeichnet, dass**
die zweite Decodierungsregel dahin gehend lautet, dass die Informationswerte von Codewörtern einer feststehenden Länge abgeleitet sind, die eine identische Anzahl von Informationswerten aufweisen, wobei die Informationswerte von Kombinationen von Informationswerten abgeleitet sind, bei denen zumindest zwei Informationswerte kombiniert sind, die durch ein Codewort einer feststehenden Länge dargestellt sind.

9. Decodierer gemäß Anspruch 8, bei dem die erste Decodierungsregel dahin gehend lautet, dass das Ableiten der Informationswerte ein Verwenden eines Huffman-Codebuches umfasst.

10. Decodierer gemäß Anspruch 8, bei dem die zweite Decodierungsregel dahin gehend lautet, dass das Ableiten der Informationswerte ein Zuweisen einer Kombination von Informationswerten, bei der zumindest zwei Informationswerte kombiniert sind, zu einem PCM-Codewort der codierten Darstellung umfasst.

11. Decodierer gemäß Anspruch 8, bei dem die codierte Darstellung von Informationswerten auf Informationswerten beruht, die Parameter umfassen, die einen Rahmen eines Audiosignals beschreiben.

12. Decodierer gemäß Anspruch 8, bei dem die codierte Darstellung von Informationswerten auf Informationswerten beruht, die BCC-Parameter umfassen, die die räumlichen Eigenschaften eines Mehrkanalaudiosignals beschreiben, und bei dem die BCC-Parameter aus der folgenden Liste von BCC-Parametern ausgewählt sind:
ICC (Zwischen-Kanal-Kohärenz/-Korrelation)
ICLD (Zwischen-Kanal-Pegel-Differenz)
ICTD (Zwischen-Kanal-Zeit-Differenz)
IPD (Zwischen-Kanal-Phase-Differenz).

13. Ein Verfahren zum verlustfreien Codieren von Informationswerten, die ein Audiosignal beschreiben, wobei die Informationswerte durch mehr als ein Bit beschrieben werden, um eine codierte Darstellung der Informationswerte abzuleiten, wobei das Verfahren folgende Schritte umfasst:
Schätzen einer Anzahl von Informationseinheiten, die zum Codieren der Informationswerte unter Verwendung einer ersten Codierungsregel und unter Verwendung einer zweiten Codierungsregel benötigt werden,
wobei die erste Codierungsregel dahin gehend lautet, dass die Informationswerte, wenn sie codiert werden, zu codierten Darstellungen führen, die eine unterschiedliche Anzahl von Informationseinheiten aufweisen, **dadurch gekennzeichnet, dass**
die zweite Codierungsregel dahin gehend lautet, dass die Informationswerte, wenn sie codiert werden, zu codierten Darstellungen führen, die eine identische Anzahl von Informationseinheiten aufweisen, wobei die codierte Darstellung abgeleitet wird, indem ein Codewort einer feststehenden Länge einer Kombination von Informationswerten, bei der zumindest zwei Informationswerte kombiniert sind, zugewiesen wird; und
Bereitstellen einer codierten Darstellung, die unter Verwendung der Codierungsregel abgeleitet wird, was zu der kleineren Anzahl von Informationseinheiten für die codierte Darstellung führt, und Bereitstellen von Regelinformationen, die die Codierungsregel angeben, auf der die codierte Darstellung beruht.

14. Ein Verfahren zum Decodieren einer codierten Darstellung von Informationswerten, die ein Audiosignal beschreiben, wobei die Informationswerte durch mehr als ein Bit beschrieben werden, und zum Verarbeiten von Regelinformationen, die eine zum Codieren der Informationswerte verwendete Codierungsregel angeben, wobei das Verfahren folgende Schritte umfasst:
Empfangen der codierten Darstellung und der Regelinformationen; und
Decodieren der codierten Darstellung unter Verwendung, je nach den Regelinformationen, einer ersten Decodierungsregel oder einer zweiten Decodierungsregel,
wobei die erste Decodierungsregel dahin gehend lautet, dass die Informationswerte von Codewörtern einer feststehenden Länge abgeleitet sind, die eine unterschiedliche Anzahl von Informationseinheiten aufweisen, **dadurch gekennzeichnet, dass**
die zweite Decodierungsregel dahin gehend lautet, dass die Informationswerte von codierten Darstellungen abgeleitet sind, die eine identische Anzahl von Informationswerten aufweisen, wobei die Informationswerte von Kombinationen von Informationswerten abgeleitet sind, bei denen zumindest zwei Informationswerte kombiniert sind, die durch ein Codewort einer feststehenden Länge dargestellt sind.

15. Computerprogramm, das einen Programmcode zum Durchführen, wenn es auf einem Computer läuft, eines Verfahrens zum verlustfreien Codieren von Informationswerten umfasst, die ein Audiosignal beschreiben, wobei die Informationswerte durch mehr als ein Bit beschrieben werden, um eine codierte Darstellung der Informationswerte abzuleiten, wobei das Verfahren folgende Schritte umfasst:
Schätzen einer Anzahl von Informationseinheiten, die zum Codieren der Informationswerte unter Verwendung einer ersten Codierungsregel und unter Verwendung einer zweiten Codierungsregel benötigt werden,
wobei die erste Codierungsregel dahin gehend lautet, dass die Informationswerte, wenn sie codiert werden, zu codierten Darstellungen führen, die eine unterschiedliche Anzahl von Informationseinheiten aufweisen, **dadurch gekennzeichnet, dass**
die zweite Codierungsregel dahin gehend lautet, dass die Informationswerte, wenn sie codiert werden, zu codierten Darstellungen führen, die eine identische Anzahl von Informationseinheiten aufweisen, wobei die codierte Darstellung abgeleitet wird, indem ein einziges Codewort einer feststehenden Länge einer Kombination von Informationswerten, bei der zumindest zwei Informationswerte kombiniert sind, zugewiesen wird; und
Bereitstellen einer codierten Darstellung, die unter Verwendung der Codierungsregel abgeleitet wird, was zu der kleineren Anzahl von Informationseinheiten für die codierte Darstellung führt, und Bereitstellen von Regelinformationen, die die Codierungsregel angeben, auf der die codierte Darstellung beruht.

16. Computerprogramm, das einen Programmcode zum Durchführen, wenn es auf einem Computer abläuft, eines Verfahrens zum Decodieren einer codierten Darstellung von Informationswerten umfasst, die ein Audiosignal beschreiben, wobei die Informationswerte durch mehr als ein Bit beschrieben werden, und zum Verarbeiten von Regelinformationen, die eine zum Codieren der Informationswerte verwendete Codierungsregel angeben, wobei das Verfahren folgende Schritte umfasst:
Empfangen der codierten Darstellung und der Regelinformationen; und
Decodieren der codierten Darstellung unter Verwendung, je nach den Regelinformationen, einer ersten Decodierungsregel oder einer zweiten Decodierungsregel,
wobei die erste Decodierungsregel dahin gehend lautet, dass die Informationswerte von codierten Darstellungen abgeleitet sind, die eine unterschiedliche Anzahl von Informationseinheiten aufweisen; und **dadurch gekennzeichnet, dass**
die zweite Decodierungsregel dahin gehend lautet, dass die Informationswerte von Codewörtern einer feststehenden Länge abgeleitet sind, die eine identische Anzahl von Informationswerten aufweisen, wobei die Informationswerte von Kombinationen von Informationswerten abgeleitet sind, bei denen zumindest zwei Informationswerte kombiniert sind, die durch ein Codewort einer feststehenden Länge dargestellt sind.

17. Codierte Darstellung von Informationswerten, die ein Audiosignal beschreiben, wobei die codierte Darstellung Folgendes umfasst:
einen ersten Teil, der unter Verwendung einer ersten Codierungsregel erzeugt wird, wobei die erste Codierungsregel dahin gehend lautet, dass die Informationswerte, wenn sie codiert werden, zu codierten Darstellungen führen, die eine unterschiedliche Anzahl von Informationseinheiten aufweisen, **dadurch gekennzeichnet, dass**
ein zweiter Teil unter Verwendung einer zweiten Codierungsregel erzeugt wird, wobei die zweite Codierungsregel dahin gehend lautet, dass die Informationswerte, wenn sie codiert werden, zu Codewörtern einer feststehenden Länge führen, die eine identische Anzahl von Informationseinheiten aufweisen, wobei die codierte Darstellung aus einer Kombination von Informationswerten abgeleitet wird, bei der zumindest zwei Informationswerte kombiniert sind, die durch ein Codewort einer feststehenden Länge dargestellt sind; und Regelinformationen, die die verwendete Codierungsregel angeben.

18. Codierte Darstellung gemäß Anspruch 17, die auf einem computerlesbaren Medium gespeichert ist.

## Revendications

1. Codeur pour le codage sans perte de valeurs de données décrivant un signal audio, les valeurs de données étant décrites par plus d'un bit, pour dériver une représentation codée des valeurs de données, comprenant:
un estimateur de bits adapté pour estimer un nombre d'unités de données requises pour coder les valeurs de données à l'aide d'une première règle de codage et à l'aide d'une deuxième règle de codage,
la première règle de codage étant telle que les valeurs de données, lorsqu'elles sont codées, résultent en des représentations codées présentant des nombres différents d'unités de données,
**caractérisé par le fait que**
la deuxième règle de codage est telle que les valeurs de données, lorsqu'elles sont codées, résultent en des représentations codées présentant des nombres identiques d'unités de données, où la représentation codée est dérivée en attribuant un seul mot de code de longueur fixe à une combinaison de valeurs de données présentant au moins deux valeurs de données combinées; et
un fournisseur adapté pour fournir une représentation codée dérivée à l'aide de la règle de codage résultant en le nombre d'unités de données le plus petit pour la représentation codée et pour fournir une information de règle indiquant la règle de codage sur laquelle se base la représentation codée.

2. Codeur selon la revendication 1, dans lequel la première règle de codage est telle que le nombre d'unités de données requises par la représentation codée d'un nombre fixe de valeurs de données dépend des valeurs de données à la base.

3. Codeur selon la revendication 1, dans lequel la première règle de codage est telle que la dérivation de la représentation codée comporte l'utilisation d'un livre de codes de Huffman.

4. Codeur selon la revendication 1, dans lequel la première règle de codage est telle que la dérivation de la représentation codée comporte le fait de dériver une représentation codée de manière différentielle des valeurs de données.

5. Codeur selon la revendication 4, dans lequel la représentation codée de manière différentielle est codée de manière différentielle dans le temps ou en fréquence.

6. Codeur selon la revendication 1, dans lequel les valeurs de données comportent des paramètres BCC décrivant les propriétés spatiales d'un signal audio multicanal et dans lequel les paramètres BCC sont choisis parmi la liste suivante de paramètres BCC:
ICC (cohérence/corrélation entre canaux)
ICLD (différence de niveau entre canaux)
ICTD (différence de temps entre canaux)
IPD (différence de phase entre canaux).

7. Codeur selon la revendication 1, dans lequel les unités de données sont des bits.

8. Décodeur pour décoder une représentation codée de valeurs de données décrivant un signal audio qui sont décrites par plus d'un bit et pour traiter une information de règle indiquant une règle de codage utilisée pour coder les valeurs de données, comprenant:
un récepteur destiné à recevoir la représentation codée et l'information de règle; et
un décompresseur destiné à décoder la représentation codée, le décompresseur étant opérationnel pour dériver les valeurs de données, en fonction de l'information de règle, à l'aide d'une première règle de décodage ou d'une deuxième règle de décodage,
la première règle de décodage étant telle que les valeurs de données sont dérivées de représentations codées présentant des nombres différents d'unités de données ; et
**caractérisé par le fait que**
la deuxième règle de décodage est telle que les valeurs de données sont dérivées de mots de code de longueur fixe présentant des nombres identiques de valeurs de données, dans lequel les valeurs de données sont dérivées de combinaisons des valeurs de données présentant au moins deux valeurs de données combinées qui sont représentées par un seul mot de code de longueur fixe.

9. Décodeur selon la revendication 8, dans lequel la première règle de décodage est telle que la dérivation des valeurs de données comporte l'utilisation d'un livre de codes de Huffman.

10. Décodeur selon la revendication 8, dans lequel la deuxième règle de décodage est telle que la dérivation des valeurs de données comporte l'attribution d'une combinaison de valeurs de données présentant au moins deux valeurs de données combinées à un mot de code PCM de la représentation codée.

11. Décodeur selon la revendication 8, dans lequel la représentation codée de valeurs de données se base sur des valeurs de données comprenant des paramètres décrivant une trame d'un signal audio.

12. Décodeur selon la revendication 8, dans lequel la représentation codée de valeurs de données se base sur des valeurs de données comprenant des paramètres BCC décrivant les propriétés spatiales d'un signal audio multicanal et dans lequel les paramètres BCC sont choisis parmi la liste suivante de paramètres BCC:
ICC (cohérence/corrélation entre canaux)
ICLD (différence de niveau entre canaux)
ICTD (différence de temps entre canaux)
IPD (différence de phase entre canaux).

13. Procédé pour le codage sans perte de valeurs de données décrivant un signal audio, les valeurs de données étant décrites par plus d'un bit, pour dériver une représentation codée des valeurs de données, le procédé comprenant:
estimer un nombre d'unités de données requises pour coder les valeurs de données à l'aide d'une première règle de codage et à l'aide d'une deuxième règle de codage,
la première règle de codage étant telle que les valeurs de données, lorsqu'elles sont codées, résultent en des représentations codées présentant des nombres différents d'unités de données,
**caractérisé par le fait que**
la deuxième règle de codage est telle que les valeurs de données, lorsqu'elles sont codées, résultent en des représentations codées présentant des nombres identiques d'unités de données, où la représentation codée est dérivée en attribuant un mot de code de longueur fixe d'une combinaison de valeurs de données présentant au moins deux valeurs de données combinées; et
fournir une représentation codée dérivée à l'aide de la règle de codage résultant en le nombre d'unités de données le plus petit pour la représentation codée et pour fournir une information de
règle indiquant la règle de codage sur laquelle se base la représentation codée.

14. Procédé pour décoder une représentation codée de valeurs de données décrivant un signal audio, les valeurs de données décrites par plus d'un bit, et pour traiter une information de règle indiquant une règle de codage utilisée pour coder les valeurs de données, le procédé comprenant:
recevoir la représentation codée et l'information de règle; et
décoder la représentation codée, en fonction de l'information de règle, à l'aide d'une première règle de décodage ou d'une deuxième règle de décodage,
la première règle de décodage étant telle que les valeurs de données sont dérivées de mots de code de longueur fixe présentant des nombres différents d'unités de données et à l'aide d'une deuxième règle de décodage,
**caractérisé par le fait que**
la deuxième règle de décodage est telle que les valeurs de données sont dérivées de représentations codées présentant des nombres identiques de valeurs de données, où les valeurs de données sont dérivées de combinaisons de valeurs de données présentant au moins deux valeurs de données combinées qui sont représentées par un seul mot de code de longueur fixe.

15. Programme d'ordinateur ayant un code de programme pour réaliser, lorsqu'il est exécuté sur un ordinateur, un procédé pour le codage sans pertes de valeurs de données décrivant un signal audio, les valeurs de données étant décrites par plus d'un bit, pour dériver une représentation codée des valeurs de données, le procédé comprenant:
estimer un nombre d'unités de données requises pour coder les valeurs de données à l'aide d'une première règle de codage et à l'aide d'une deuxième règle de codage,
la première règle de codage étant telle que les valeurs de données, lorsqu'elles sont codées, résultent en des représentations codées présentant des nombres différents d'unités de données,
**caractérisé par le fait que**
la deuxième règle de codage est telle que les valeurs de données, lorsqu'elles sont codées, résultent en des représentations codées présentant des nombres identiques d'unités de données, où la représentation codée est dérivée en attribuant un seul mot de code de longueur fixe à une combinaison de valeurs de données présentant au moins deux valeurs de données combinées; et
fournir une représentation codée dérivée à l'aide de la règle de codage résultant en le nombre d'unités de données le plus petit pour la représentation codée et pour fournir une information de règle indiquant la règle de codage sur laquelle se base la représentation codée.

16. Programme d'ordinateur ayant un code de programme pour réaliser, lorsqu'il est exécuté sur un ordinateur, un procédé pour décoder une représentation codée de valeurs de données décrivant un signal audio, les valeurs de données étant décrites par plus d'un bit, et pour traiter une information de règle indiquant une règle de codage utilisée pour coder les valeurs de données, le procédé comprenant:
recevoir la représentation codée et l'information de règle; et
décoder la représentation codée, en fonction de l'information de règle, à l'aide d'une première règle de décodage ou d'une deuxième règle de décodage,
la première règle de décodage étant telle que les valeurs de données sont dérivées de représentations codées présentant des nombres différents d'unités de données, et
**caractérisé par le fait que**
la deuxième règle de décodage est telle que les valeurs de données sont dérivées de mots de code de longueur fixe présentant des nombres identiques de valeurs de données, où les valeurs de données sont dérivées de combinaisons de valeurs de données présentant au moins deux valeurs de données combinées qui sont représentées par un seul mot de code de longueur fixe.

17. Représentation codée de valeurs de données décrivant un signal audio, dans laquelle la représentation codée comporte:
une première partie générée à l'aide d'une première règle de codage, la première règle de codage étant telle que les valeurs de données, lorsqu'elles sont codées, résultent en des représentations codées présentant des nombres différents d'unités de données;
**caractérisé par le fait que**
une deuxième partie est générée à l'aide d'une deuxième règle de codage, la deuxième règle de codage étant telle que les valeurs de données, lorsqu'elles sont codées, résultent en des mots de code de longueur fixe présentant des nombres identiques d'unités de données, où la représentation codée est dérivée d'une combinaison de valeurs de données présentant au moins deux valeurs de données combinées qui sont représentées par un seul mot de code de longueur fixe; et
une information de règle indiquant la règle de codage utilisée.

18. Représentation codée selon la revendication 17, qui est mémorisée sur un support pouvant être lu sur un ordinateur.
